# EUROPEAN PATENT APPLICATION

(11) **EP 4 506 984 A2**
(43) Date of publication of application: **12.02.2025**
(21) Application number: 24189961.6
(22) Date of filing: 22.07.2024
(51) Int. Cl.: H01L 21/67, H01L 21/687

(54) **SUBSTRATE PROCESSING APPARATUS AND SUBSTRATE PROCESSING METHOD**

(30) Priority: 10.08.2023 JP 2023131181
(71) Applicant: SCREEN Holdings Co., Ltd., Kyoto-shi, Kyoto 602-8585 (JP)
(72) Inventor: ZHANG, Song, Kyoto-shi, 602-8585 (JP); KUANG, Chen, Kyoto-shi, 602-8585 (JP); HIGUCHI, Ayumi, Kyoto-shi, 602-8585 (JP); SHINOHARA, Kensuke, Kyoto-shi, 602-8585 (JP)
(74) Representative: Kilian Kilian & Partner mbB

(57) **Abstract**

A substrate processing apparatus includes one or more peeling gas nozzles that tears a polymer film by a pressure of a peeling gas such that a peeled portion peeled from an upper surface of a substrate and an adhering portion adhering to the upper surface are included in the polymer film by discharging the peeling gas at a first rate toward the upper surface, and then changes the adhering portion to the peeled portion with the peeling gas that has entered between the peeled portion and the substrate while discharging the peeling gas at a second rate slower than the first rate toward the upper surface, and a nozzle actuator that changes a distance from a hit position of the peeling gas with respect to the upper surface to a center of the substrate by moving the one or more peeling gas nozzles horizontally.

## Description

### BACKGROUND OF THE INVENTION

### 1. Field of the Invention

The present invention relates to a substrate processing apparatus and a substrate processing method that process substrates. The substrates include a semiconductor wafer, a substrate for a FPD (flat panel display) such as a liquid crystal display and an organic EL (electroluminescence) display, a substrate for an optical disc, a substrate for a magnetic disc, a substrate for a magneto-optical disc, a substrate for a photomask, a ceramic substrate, a substrate for a solar cell and the like, for example.

### 2. Description of Related Art

JP 2015095583 A discloses a substrate cleaning method and substrate cleaning system that remove particles from a substrate using a processing film. In this method and system, a film-forming processing solution for formation of a processing film is supplied to a substrate with a hydrophilic surface. A peeling treatment solution for peeling of the processing film from the substrate is then supplied to the substrate, after which a dissolution processing solution for dissolution of the processing film is supplied to the substrate.

In the method and system described in JP 2015095583 A, however, a peeling treatment solution must be supplied to the substrate to peel the processing film from the substrate, and this increases consumption of the processing liquid.

At least one preferred embodiment of the present invention provides a substrate processing apparatus and substrate processing method that are capable of peeling a polymer film from a substrate without using a peeling liquid.

### SUMMARY OF THE INVENTION

A preferred embodiment of the present invention provides a substrate processing apparatus including a substrate holder that horizontally holds a substrate having an upper surface covered with a solid or semi-solid polymer film, one or more peeling gas nozzles that tears the polymer film by a pressure of a peeling gas such that a peeled portion that has been peeled from the upper surface of the substrate and an adhering portion adhering to the upper surface of the substrate are included in the polymer film by discharging the peeling gas at a first rate toward the upper surface of the substrate held by the substrate holder, and then changes the adhering portion to the peeled portion with the peeling gas that has entered between the peeled portion and the substrate while discharging the peeling gas at a second rate which is slower than the first rate toward the upper surface of the substrate held by the substrate holder, and a nozzle actuator that changes a distance from a hit position of the peeling gas with respect to the upper surface of the substrate to a center of the substrate by moving the one or more peeling gas nozzles horizontally.

In the preferred embodiment, at least one of the following features may be added to the substrate processing apparatus.

The nozzle actuator positions the one or more peeling gas nozzles at a first discharge position in which the peeling gas hits a non-device-forming region within the upper surface of the substrate when the one or more peeling gas nozzles are discharging the peeling gas at the first rate, and moves the one or more peeling gas nozzles to a position in which the peeling gas hits a device-forming region within the upper surface of the substrate when the one or more peeling gas nozzles are discharging the peeling gas at the second rate.

The polymer film is a solid or semi-solid film containing a water-soluble polymer, and the substrate processing apparatus further includes a rinse liquid nozzle that discharges rinse liquid containing water toward the upper surface of the substrate held by the substrate holder, after the polymer film has been peeled from the upper surface of the substrate.

The substrate processing apparatus further includes a tubular guard that receives the polymer film and rinse liquid that have scattered around the substrate from the upper surface of the substrate held by the substrate holder.

The polymer film is a solid or semi-solid film containing a water-soluble polymer, and the water contact angle with respect to the upper surface of the substrate is 32° or greater.

The substrate processing apparatus further includes a polymer solution nozzle that discharges a polymer solution toward the upper surface of the substrate held by the substrate holder, and a heat source that generates heat to convert the liquid film of the polymer solution on the substrate to the polymer film.

The one or more peeling gas nozzles discharge the peeling gas toward the upper surface of the substrate held by the substrate holder, until the entire polymer film is peeled from the upper surface of the substrate without being separated.

The one or more peeling gas nozzles are a single peeling gas nozzle that discharges the peeling gas at the first rate and discharges the peeling gas at the second rate, the substrate processing apparatus further includes a flow rate adjustment valve that varies the flow rate of the peeling gas supplied to the one peeling gas nozzle, and the one peeling gas nozzle is a variable opening nozzle an opening area of which decreases when a flow rate of the peeling gas supplied to the peeling gas nozzle increases and the opening area of which increases when the flow rate of the peeling gas supplied to the peeling gas nozzle decreases.

The variable opening nozzle includes an outer tube including a discharge port that discharges the peeling gas, an inner tube including a tip opening that discharges the peeling gas within the outer tube, and an elastic body that supports the inner tube within the outer tube, the elastic body undergoing elastic deformation to a first form in which the tip opening of the inner tube is disposed outside of the outer tube while the inner tube is inserted in the discharge port of the outer tube, when the flow rate of the peeling gas supplied within the outer tube increases to the first flow rate, and returning to a second form in which the entire inner tube is disposed in the outer tube, when the flow rate of the peeling gas supplied within the outer tube decreases from the first flow rate to the second flow rate.

Another preferred embodiment of the present invention provides a substrate processing method including a substrate holding step of horizontally holding a substrate having an upper surface covered with a solid or semi-solid polymer film, a peeled portion-forming step of tearing the polymer film by a pressure of a peeling gas such that a peeled portion that has been peeled from the upper surface of the substrate and an adhering portion adhering to the upper surface of the substrate are included in the polymer film, by discharging the peeling gas at a first rate toward the upper surface of the substrate through one or more peeling gas nozzles, and a peeled portion-widening step of converting the adhering portion to the peeled portion with the peeling gas that has entered between the peeled portion and the substrate by moving the one or more peeling gas nozzles horizontally while discharging the peeling gas toward the upper surface of the substrate through the one or more peeling gas nozzles at a second rate which is slower than the first rate. According to this method, the same advantages as the above-described substrate processing apparatus can be obtained. At least one of the above-described features regarding the substrate processing apparatus may be added to the substrate processing method. The following features may be added to the substrate processing method, for example.

The peeled portion-forming step includes a step of positioning the one or more peeling gas nozzles at a first discharge position in which the peeling gas hits a non-device-forming region within the upper surface of the substrate, when the one or more peeling gas nozzles discharge the peeling gas at the first rate, and the peeled portion-widening step includes a step of moving the one or more peeling gas nozzles to a position in which the peeling gas hits a device-forming region within the upper surface of the substrate, when the one or more peeling gas nozzles discharge the peeling gas at the second rate.

The polymer film is a solid or semi-solid film containing a water-soluble polymer, and the substrate processing method further includes a rinse liquid supply step of causing a rinse liquid nozzle to discharge rinse liquid containing water toward the upper surface of the substrate, after the polymer film has been peeled from the upper surface of the substrate.

The substrate processing method further includes a receiving step of receiving the polymer film and rinse liquid that have scattered around the substrate from the upper surface of the substrate by a tubular guard.

The substrate processing method further includes, prior to the peeled portion-forming step, a polymer solution supply step of causing a polymer solution nozzle to discharge polymer solution toward the upper surface of the substrate prior to the peeled portion-forming step, and a polymer film forming step of converting a liquid film of the polymer solution on the substrate to the polymer film by heat generated from a heat source.

The peeled portion-widening step includes a step of causing the one or more peeling gas nozzles to discharge the peeling gas toward the upper surface of the substrate until the entire polymer film is peeled from the upper surface of the substrate without being separated.

The above and other objects, features and advantages of the present invention will become more apparent from the following detailed description of the preferred embodiments with reference to the attached drawings.

### BRIEF DESCRIPTION OF THE DRAWINGS

FIG. 1A is a schematic plan view showing a layout of a substrate processing apparatus according to a preferred embodiment of the present invention.
FIG. 1B is a schematic side view of the substrate processing apparatus.
FIG. 2 is a schematic view of an interior of a processing unit provided in the substrate processing apparatus when viewed horizontally.
FIG. 3A to 3D are schematic cross-sectional views of a peeling gas nozzle.
FIG. 4 is a block diagram showing an electrical arrangement of the substrate processing apparatus.
FIG. 5 is a process chart for describing an example of processing of a substrate performed by the substrate processing apparatus.
FIG. 6 is a time chart showing an example of change in flow velocity of the peeling gas when carrying out a polymer film peeling step.
FIG. 7A is a diagram of a substrate viewed horizontally, while carrying out a polymer film peeling step.
FIG. 7B is a diagram showing a vertical cross-section of a substrate, while carrying out the polymer film peeling step.
FIG. 7C is a diagram showing a vertical cross-section of a substrate, while carrying out the polymer film peeling step.
FIG. 7D is a diagram of a substrate viewed from above, while carrying out the polymer film peeling step.
FIG. 7E is a diagram of a substrate viewed from above, while carrying out the polymer film peeling step.
FIG. 7F is a diagram of a substrate viewed horizontally, while carrying out the polymer film peeling step.
FIG. 7G is a diagram of a substrate viewed horizontally, while carrying out the polymer film peeling step.
FIG. 7H is a diagram of a substrate viewed horizontally, while carrying out a rinse liquid supply step.
FIG. 8 is a schematic plan view of a substrate showing a non-device-forming region and device-forming regions.

### DETAILED DESCRIPTION OF PREFERRED EMBODIMENTS

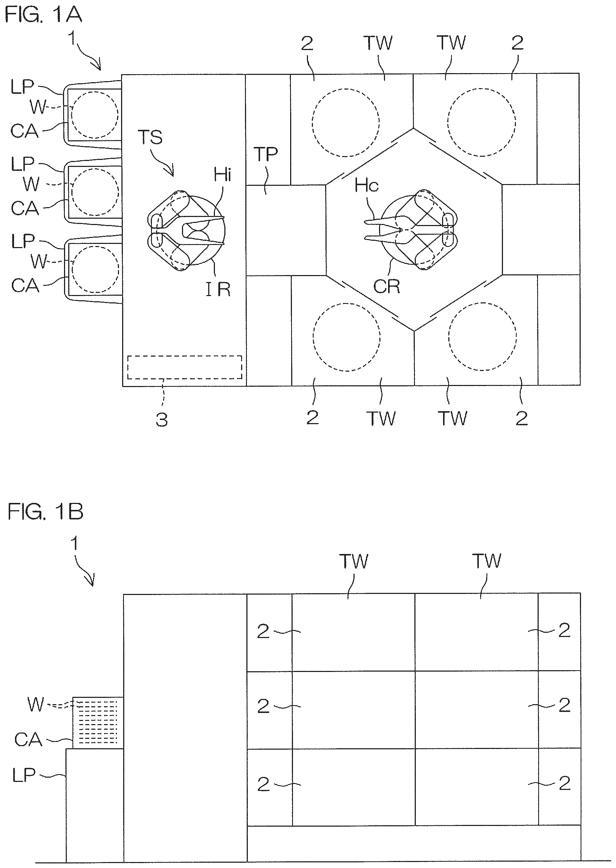

FIG. 1A is a schematic plan view showing a layout of a substrate processing apparatus 1 according to a preferred embodiment of the present invention. FIG. 1B is a schematic side view of the substrate processing apparatus 1.

The substrate processing apparatus 1 is a single substrate processing type apparatus that processes disk-shaped substrates W such as semiconductor wafers one by one. The substrate processing apparatus 1 includes load ports LP that each hold a carrier CA housing a substrate W, a plurality of processing units 2 that process each substrate W transported from the carrier CA on each of the load ports LP, using a processing fluid such as a processing liquid or processing gas, a transport system TS that transports each substrate W between the carrier CA on each of the load ports LP and the plurality of processing units 2, and a controller 3 that controls the substrate processing apparatus 1.

The plurality of processing units 2 form a plurality of towers TW. FIG. 1A shows an example where four towers TW are formed. As shown in FIG. 1B, the plurality of processing units 2 included in a single tower TW are stacked vertically. As shown in FIG. 1A, the plurality of towers TW form two rows extending in the direction of depth of the substrate processing apparatus 1, in a plan view. The two rows face each other across a transport path TP in a plan view.

The transport system TS includes an indexer robot IR that transports each substrate W between the carrier CA on each of the load ports LP and the plurality of processing units 2, and a center robot CR that transports the substrate W between the indexer robot IR and the plurality of processing units 2. The indexer robot IR is disposed between the load ports LP and the center robot CR, in a plan view. The center robot CR is disposed in the transport path TP.

The indexer robot IR includes one or more hands Hi that support the substrates W horizontally. The hands Hi are able to move in parallel in both the horizontal direction and the vertical direction, and are also rotatable around a vertical line. The hands Hi can carry in and carry out the substrates W to and from the carriers CA on the load ports LP, and can deliver the center robot CR and the substrates W.

The center robot CR includes one or more hands Hc that support the substrates W horizontally. The hands Hc are able to move in parallel in both the horizontal direction and the vertical direction, and also likewise rotatable around a vertical line. The hands Hc can deliver the indexer robot IR and the substrates W, and can carry in and carry out the substrates W to and from the processing units 2.

Next, a processing unit 2 will be described.

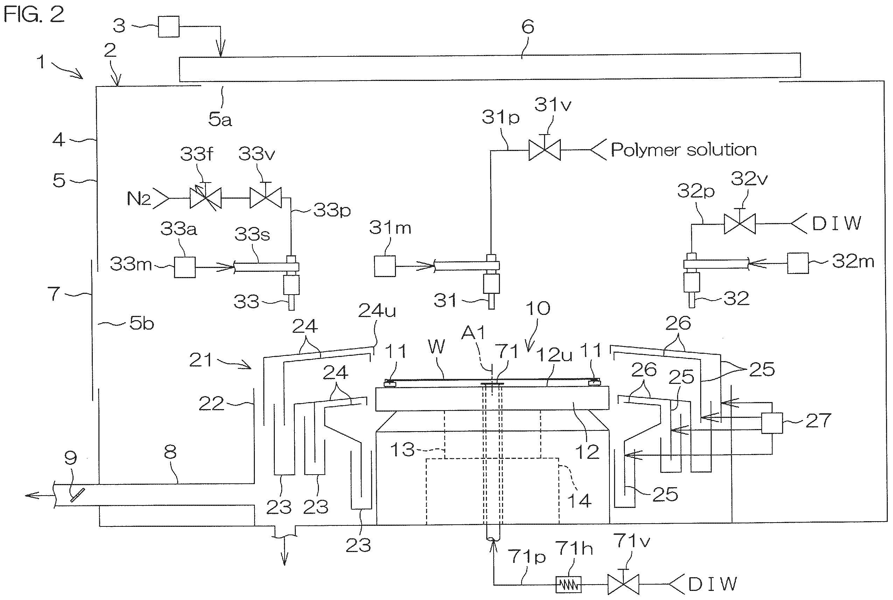

FIG. 2 is a schematic view of an interior of the processing unit 2 provided in the substrate processing apparatus 1 when viewed horizontally. Each processing unit 2 includes a box-shaped chamber 4 having an interior space, a spin chuck 10 that holds one substrate W horizontally in the chamber 4 while rotating it around a vertical rotational axis A1 running through the center of the substrate W, and a tubular processing cup 21 surrounding the spin chuck 10.

The chamber 4 includes a box-shaped partition 5 provided with a carry-in conveying exit 5b through which the substrate W passes, and a door 7 that opens and closes the carry-in conveying exit 5b. An FFU (fan filter unit) 6 is disposed on an air outlet 5a provided on top of the partition 5. The FFU 6 constantly supplies clean air (air that has been filtered by a filter) from the air outlet 5a to the chamber 4. The gas in the chamber 4 is discharged from the chamber 4 through an exhaust air duct 8 connected to the bottom portion of the processing cup 21. Thereby, a constant downflow of clean air is formed inside the chamber 4. The flow rate of discharged gas emitted through the exhaust air duct 8 changes with the opening degree of an exhaust gas valve 9 disposed in the exhaust air duct 8.

The spin chuck 10 includes a disk-shaped spin base 12 which is horizontally held, a plurality of chuck pins 11 which hold the substrate W horizontally above the spin base 12, a spin shaft 13 extending downward from the center of the spin base 12, and a spin motor 14 that rotates the spin base 12 and the plurality of chuck pins 11 by rotating the spin shaft 13.

The spin chuck 10 is not limited to being a gripping chuck that contacts the plurality of chuck pins 11 with the edges of substrate W, and instead it may be a vacuum-type chuck that holds the substrate W horizontally by adsorbing the rear surface (lower surface) of the substrate W (the non-device forming surface) onto the upper surface 12u of the spin base 12. When the spin chuck 10 is a gripping chuck, the plurality of chuck pins 11 constitute the substrate holder. When the spin chuck 10 is a vacuum-type chuck, the spin base 12 constitutes the substrate holder.

The processing cup 21 includes a plurality of guards 24 that receive processing liquid discharged around the substrate W, a plurality of cups 23 that receive the processing liquid guided downward by the plurality of guards 24, and a cylindrical outer wall member 22 surrounding the plurality of guards 24 and the plurality of cups 23. FIG. 2 shows an example where four guards 24 and three cups 23 are provided, the outermost side cup 23 being integral with the 3rd guard 24 from the top.

Each guard 24 includes a cylinder portion 25 surrounding the spin chuck 10, and a toric ceiling portion 26 extending upward obliquely from the top edge of the cylinder portion 25 toward the rotational axis A1. The plurality of ceiling portions 26 overlap in the vertical direction, and the plurality of cylinder portions 25 are disposed in a concentric manner. The toric upper end of each ceiling portion 26 corresponds to the upper end 24u of the guard 24 surrounding the substrate W and the spin base 12, in a plan view. The plurality of cups 23 are each disposed below the plurality of cylinder portions 25. Each cup 23 forms an annular groove that receives processing liquid guided downward by the guard 24.

The processing unit 2 includes a guard raising/lowering unit 27 that individually raises and lowers the plurality of guards 24. The guard raising/lowering unit 27 positions the guard 24 at a desired position in a range between the upper position and lower position. FIG. 2 shows a state where two guards 24 are disposed at the upper position and the remaining two guards 24 are disposed at the lower position. The upper position is a position such that the upper end 24u of the guard 24 is disposed higher than the holding position where the substrate W held by the spin chuck 10 is positioned. The lower position is a position such that the upper end 24u of the guard 24 is disposed lower than the holding position.

The processing unit 2 includes a plurality of nozzles that discharge processing liquid toward the substrate W held by the spin chuck 10. The plurality of nozzles include a polymer solution nozzle 31 that discharges the polymer solution toward the upper surface of the substrate W, a rinse liquid nozzle 32 that discharges the rinse liquid toward the upper surface of the substrate W, and a peeling gas nozzle 33 that discharges the peeling gas toward the upper surface of the substrate W. The plurality of nozzles also include a lower surface nozzle 71, described below.

The polymer solution nozzle 31 may be a scan nozzle that moves the hit position of the polymer solution on the substrate W within the upper surface of the substrate W, or it may be a fixed nozzle that cannot move the hit position of the polymer solution on the substrate W. The same applies for the other nozzles as well. FIG. 2 shows an example in which the polymer solution nozzle 31, rinse liquid nozzle 32 and peeling gas nozzle 33 are scan nozzles.

The polymer solution nozzle 31 is connected to a polymer solution tube 31p that guides the polymer solution to the polymer solution nozzle 31. When a polymer solution valve 31v mounted on the polymer solution tube 31p is opened, the polymer solution is continuously discharged downward from the discharge port of the polymer solution nozzle 31.

While not shown in the drawing, the polymer solution valve 31v includes a valve body provided with an annular valve seat through which polymer solution runs, a valve element that can move with respect to the valve seat, and an actuator that moves the valve element between a closed position where the valve element contacts the valve seat and an open position where the valve element is away from the valve seat. The same applies for the other valves as well. The actuator may be a pneumatic actuator or an electric actuator, or a different type of actuator. The controller 3 opens and closes the polymer solution valve 31v by controlling the actuator.

The polymer solution nozzle 31 is connected to a nozzle-moving unit 31m that moves the polymer solution nozzle 31 in either or both the vertical direction and horizontal direction. The nozzle-moving unit 31m moves the polymer solution nozzle 31 horizontally between a processing position where polymer solution discharged from the polymer solution nozzle 31 is supplied onto the upper surface of the substrate W, and a standby position where the polymer solution nozzle 31 is located on the outside of the processing cup 21, in a plan view.

The polymer solution is a solution containing the polymer corresponding to the solute, and a solvent that dissolves the polymer. The polymer is a water-soluble polymer (hydrophilic polymer) which dissolves in water, and the solvent is water. The polymer solution is therefore a water-soluble polymer solution. The polymer solution may also contain components other than the water-soluble polymer and water. The solvent may be a liquid of an amphiphilic substance having a hydrophilic group and a hydrophobic group in the same molecule, while the polymer may be a hydrophobic polymer that (essentially) does not dissolve in water. In this case, the solvent may be a liquid of an organic solvent, or a liquid of a substance other than an organic solvent.

The water-soluble polymer is a polymer having a hydrophilic group such as a carboxyl, hydroxyl or sulfonic acid group disposed at an end of the molecule. The water-soluble polymer may include one or more water-soluble acrylic resins, water-soluble polyesters and water-soluble polyurethanes, or it may include a polymer other than these. A water-soluble acrylic resin may be either or both an OH group acrylic resin and a hydroxyl acrylic resin. The water-soluble polymer may be either a polymer that (essentially) does not dissolve in oils, or a polymer that optionally also dissolves in oils. In the latter case, the solubility of the water-soluble polymer in water is greater than the solubility of the water-soluble polymer in oil.

The upper surface of the substrate W is one of the sides in contact with the atmosphere in the space in which the substrate W is set. The upper surface of the substrate W just before contact with the polymer solution may be either hydrophobic or hydrophilic. The water contact angle on the upper surface of the substrate W just before contact with the polymer solution may be 32° or greater, or it may be less than 32°. At least a portion of the upper surface of the substrate W may be made of silicon carbonitride (SiCN), or it may be made of amorphous carbon. The water contact angle on silicon carbonitride is 62°, and the water contact angle on amorphous carbon is 50° to 60°. However, the material of the upper surface of the substrate W is not limited to being silicon carbonitride or amorphous carbon.

The rinse liquid nozzle 32 is connected to a rinse liquid tube 32p that guides the rinse liquid to the rinse liquid nozzle 32. When the rinse liquid valve 32v attached to the rinse liquid tube 32p is opened, the rinse liquid is continuously discharged downward from the discharge port of the rinse liquid nozzle 32. FIG. 2 shows an example in which the rinse liquid nozzle 32 discharges DIW (Deionized Water), which is a type of purified water. The rinse liquid discharged from the rinse liquid nozzle 32 may be carbonated water, electrolytic ion water, hydrogen water, ozone water or hydrochloric acid water at a diluted concentration (such as about 10 to 100 ppm), or it may be a different liquid.

The rinse liquid nozzle 32 is connected to a nozzle-moving unit 32m that moves the rinse liquid nozzle 32 in either or both the vertical direction and horizontal direction. The nozzle-moving unit 32m moves the rinse liquid nozzle 32 horizontally between a processing position where rinse liquid discharged from the rinse liquid nozzle 32 is supplied onto the upper surface of the substrate W, and a standby position where the rinse liquid nozzle 32 is located on the outside of the processing cup 21, in a plan view.

The peeling gas nozzle 33 is connected to a peeling gas tube 33p that guides the peeling gas to the peeling gas nozzle 33. When the open/close valve 33v attached to the peeling gas tube 33p is opened, the peeling gas is continuously discharged downward from the discharge port of the peeling gas nozzle 33, at a flow rate corresponding to the opening degree of the flow rate adjustment valve 33f that varies the flow rate of the peeling gas. FIG. 2 shows an example where the peeling gas nozzle 33 discharges nitrogen gas as an example of the peeling gas. The peeling gas may be an inert gas other than nitrogen gas, or it may be a gas other than an inert gas.

The peeling gas nozzle 33 is connected to a nozzle-moving unit 33m that moves the peeling gas nozzle 33 in either or both the vertical direction and horizontal direction. The nozzle-moving unit 33m moves the peeling gas nozzle 33 horizontally between a processing position where peeling gas discharged from the peeling gas nozzle 33 is supplied onto the upper surface of the substrate W, and a standby position where the peeling gas nozzle 33 is located on the outside of the processing cup 21, in a plan view.

The nozzle-moving unit 33m moves the polymer solution nozzle 31 horizontally along an arc-shaped route, in a plan view, by rotating the polymer solution nozzle 31 around a vertical line located outside of the processing cup 21. Because of the large radius of the arc-shaped route, the polymer solution nozzle 31 moves horizontal along a route that can be considered to be a straight line, in a plan view. The nozzle-moving unit 33m may also be moved in parallel horizontally, instead of rotating the polymer solution nozzle 31.

The nozzle-moving unit 33m includes a nozzle actuator 33a that generates mechanical power to move the polymer solution nozzle 31, and a support arm 33s that transmits the mechanical power of the nozzle actuator 33a to the polymer solution nozzle 31. The support arm 33s is an example of a transmitting element that transmits the mechanical power of the nozzle actuator 33a to the polymer solution nozzle 31. The polymer solution nozzle 31 is attached to the support arm 33s.

The nozzle actuator 33a is a device that converts driving energy, such as electrical, fluid, magnetic, thermal or chemical energy, to mechanical work. The nozzle actuator 33a includes an electric motor (rotary motor), linear motor, air cylinder and other devices. When the nozzle actuator 33a is an electric motor which moves the polymer solution nozzle 31 in parallel horizontally, it may convert rotation of the nozzle actuator 33a to linear motion of the polymer solution nozzle 31, using a motion converter such as a ball screw or ball nut.

The plurality of nozzles include a lower surface nozzle 71 that discharges processing fluid toward the center of the lower surface of the substrate W. The lower surface nozzle 71 includes a disc portion disposed between the upper surface 12u of the spin base 12 and the lower surface of the substrate W, and a cylindrical portion extending downward from the disc portion. The discharge port of the lower surface nozzle 71 opens at the central portion of the upper surface of the disc portion. When the substrate W is held by the spin chuck 10, the discharge port of the lower surface nozzle 71 is oriented vertically at the central portion of the lower surface of the substrate W.

The lower surface nozzle 71 is connected to a heating fluid tube 71p that guides hot water, as an example of heating fluid, to the lower surface nozzle 71. The hot water is purified water at a higher temperature than room temperature (such as 20 to 30°C). The purified water is supplied to the lower surface nozzle 71 after having been heated by a heater 71h, as an example of a heat source. When a heating fluid valve 71v attached to the heating fluid tube 71p is opened, hot water is continuously discharged upward from the discharge port of the lower surface nozzle 71. Thereby, the hot water is supplied to the lower surface of the substrate W.

Next, an example of the peeling gas nozzle 33 will now be explained.

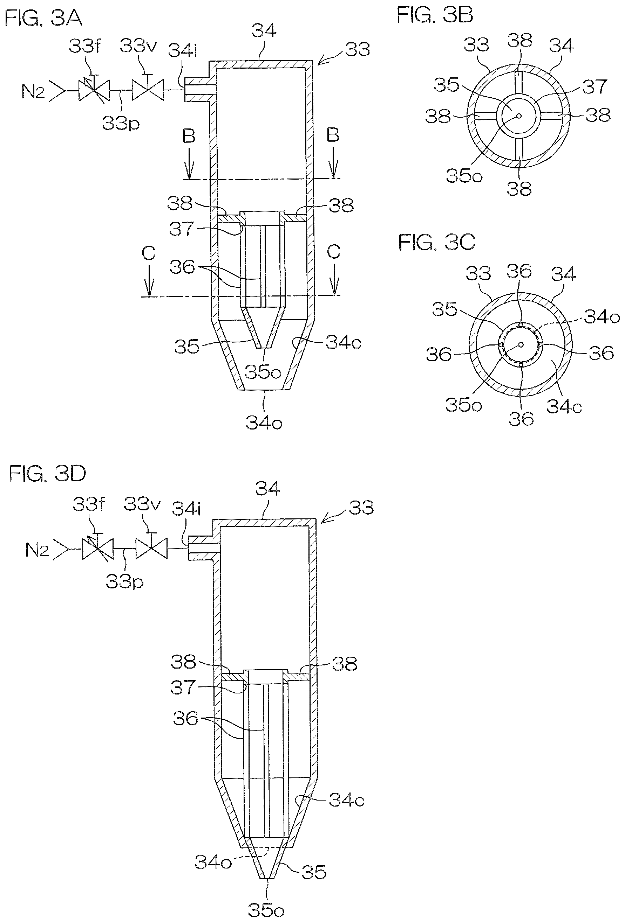

FIG. 3A is a schematic diagram showing a vertical cross-section of the peeling gas nozzle 33 with the inner tube 35 disposed at a second position. FIG. 3B is a schematic diagram showing a horizontal cross-section of the peeling gas nozzle 33 along line B-B of FIG. 3A. FIG. 3C is a schematic diagram showing a horizontal cross-section of the peeling gas nozzle 33 along line C-C of FIG. 3A. FIG. 3D is a schematic diagram showing a vertical cross-section of the peeling gas nozzle 33 with the inner tube 35 disposed at a first position.

The peeling gas nozzle 33 is a variable opening nozzle that has decreased opening area when the flow rate of the peeling gas supplied to the peeling gas nozzle 33 decreases, and has increased opening area when the flow rate of the peeling gas supplied to the peeling gas nozzle 33 decreases. The peeling gas nozzle 33 includes an outer tube 34 including a discharge port 34o that discharges peeling gas downward, an inner tube 35 including a tip opening 35o that discharges peeling gas downward inside the outer tube 34, and a plurality of elastic bodies 36 that support the inner tube 35 inside the outer tube 34.

The outer tube 34 surrounds the inner tube 35. The outer tube 34 is concentric with the inner tube 35. The outer tube 34 supports the inner tube 35 via a plurality of fixed arms 38, a fixed ring 37, and a plurality of elastic bodies 36. The fixed arms 38, the fixed ring 37 and the elastic bodies 36 are disposed in the outer tube 34.

As shown in FIG. 3B, the fixed ring 37 is concentric with the outer tube 34 and inner tube 35. The plurality of fixed arms 38 extend from the outer peripheral surface of the fixed ring 37 to the inner peripheral surface of the outer tube 34. The plurality of fixed arms 38 are disposed across intervals in the circumferential direction of the outer tube 34. The fixed ring 37 is fixed to the outer tube 34 through the plurality of fixed arms 38.

As shown in FIG. 3A and FIG. 3D, the plurality of elastic bodies 36 and inner tube 35 are disposed below the fixed ring 37. The plurality of elastic bodies 36 extend downward from the fixed ring 37 to the upper end of the inner tube 35. The inner tube 35 hangs from the fixed ring 37 by the plurality of elastic bodies 36. As shown in FIG. 3B, the plurality of elastic bodies 36 are disposed across intervals in the circumferential direction of the outer tube 34.

The discharge port 34o of the outer tube 34 is open at the lower surface of the outer tube 34. The tip opening 35o of the inner tube 35 is open at the lower surface of the inner tube 35. The discharge port 34o and tip opening 35o are two concentric circles. The diameter of the discharge port 34o is larger than the diameter of the tip opening 35o. The peeling gas guided by the peeling gas tube 33p enters into the outer tube 34 through an inlet 34i that is opened at the outer surface of the outer tube 34. The peeling gas in the outer tube 34 is discharged downward from the discharge port 34o of the outer tube 34, while also entering into the inner tube 35 from the upper end of the inner tube 35 and being discharged downward from the tip opening 35o of the inner tube 35.

The upper surface of the inner tube 35 is pushed downward by the peeling gas inside the outer tube 34. In the example shown in FIG. 3A and FIG. 3D, the inner peripheral surface of the inner tube 35 is an inverted conical shape, and therefore the inner peripheral surface of the inner tube 35 is also pushed downward by the peeling gas in the outer tube 34. The force pushing the inner tube 35 downward is transmitted to the plurality of elastic bodies 36. The plurality of elastic bodies 36 therefore expand and contract vertically in response to the gas pressure inside the outer tube 34. The elastic body 36 may be made of rubber or resin. It may be made of a material other than rubber or resin so long as the elastic body 36 has rubber elasticity.

As shown in FIG. 3D, the inner tube 35 is formed with a shape and size such that it protrudes downward from the discharge port 34o of the outer tube 34 but cannot penetrate through the outer tube 34. FIG. 3D shows an example where the maximum outer diameter of the inner tube 35 is larger than the diameter of the discharge port 34o of the outer tube 34. In this example, the outer peripheral surface of the inverted conical shape of the inner tube 35 is in contact with the conical portion 34c of the inverted conical shape provided on the inner peripheral surface of the outer tube 34, and the contact prevents movement of the inner tube 35 downward with respect to the outer tube 34. The discharge port 34o of the outer tube 34 is formed by the conical portion 34c of the inverted conical shape. The tip opening 35o of the inner tube 35 is formed by the inner peripheral surface of the inverted conical shape of the inner tube 35.

FIG. 3A shows a state where gas such as peeling gas is not supplied into the outer tube through the inlet 34i of the outer tube 34. FIG. 3D shows a state where peeling gas is supplied into the outer tube through the inlet 34i of the outer tube 34.

As shown in FIG. 3D, when the flow rate of the peeling gas supplied into the outer tube 34 increases up to the first flow rate, the elastic body 36 undergoes elastic deformation to a first form such that the tip opening 35o of the inner tube 35 is disposed outside of the outer tube 34 with the inner tube 35 inserted in the discharge port 34o of the outer tube 34. Thereby, the inner tube 35 becomes disposed at the first position shown in FIG. 3D. As shown in FIG. 3A, when the flow rate of the peeling gas supplied into the outer tube 34 decreases from the first flow rate to the second flow rate, it returns to the second form such that the entire inner tube 35 is disposed inside the outer tube 34. Thereby, the inner tube 35 thus becomes disposed at the second position shown in FIG. 3A.

When the inner tube 35 is disposed at the first position shown in FIG. 3D, the peeling gas inside the outer tube 34 exits from the tip opening 35o of the inner tube 35 through the peeling gas nozzle 33. When the inner tube 35 is disposed at the second position shown in FIG. 3A, the peeling gas inside the outer tube 34 exits from the discharge port 34o of the outer tube 34 through the peeling gas nozzle 33. Thus, when the elastic body 36 is in the first form, the tip opening 35o of the inner tube 35 serves as the exit for peeling gas, and the area of the tip opening 35o corresponds to the opening area of the peeling gas nozzle 33. When the elastic body 36 is in the second form, the discharge port 34o of the outer tube 34 serves as the exit for the peeling gas, and the area of the discharge port 34o corresponds to the opening area of the peeling gas nozzle 33.

Next, an electrical arrangement of the substrate processing apparatus 1 will be described.

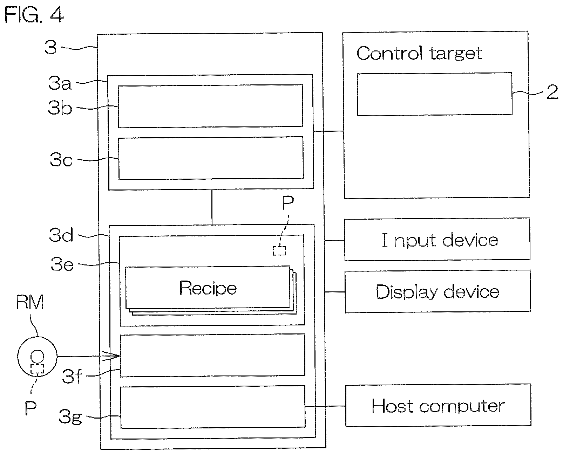

FIG. 4 is a block diagram showing the electrical arrangement of the substrate processing apparatus 1. The controller 3 includes at least one computer that can communicate with each other. The computer includes a computer main body 3a and a peripheral device 3d that is connected to the computer main body 3a. The computer main body 3a includes a CPU 3b (central processing unit) that executes various types of commands and a memory 3c that stores information. The peripheral device 3d includes a storage 3e that stores information to be sent to and received from the memory 3c such as a program P, a reader 3f that reads information from a removable medium RM and a communication device 3 g that communicates with other devices such as a host computer. The memory 3c and the storage 3e are examples of a storage device that stores information.

The controller 3 is connected to an input device and a display. The input device is operated when an operator such as a user or a maintenance operator inputs information to the substrate processing apparatus 1. The information is displayed on the screen of the display. The input device may be any one of a keyboard, a pointing device and a touch panel or may be a device other than those. A touch panel display that serves both as the input device and the display may be provided in the substrate processing apparatus 1.

The CPU 3b executes the program P stored in the storage 3e. The program P within the storage 3e may be previously installed in the controller 3, may be fed through the reader 3f from the removable medium RM to the storage 3e or may be fed from an external device such as the host computer to the storage 3e through the communication device 3g.

The memory 3c is a volatile memory that retains memory only when power is supplied. The storage 3e and the removable medium RM are non-volatile memories that retain memory even when power is not supplied. The storage 3e is, for example, a magnetic storage device such as a hard disk drive. The removable medium RM is, for example, an optical disc such as a compact disc or a semiconductor memory such as a memory card. The removable medium RM is an example of a computer readable recording medium in which the program P is recorded. The removable medium RM is a non-transitory tangible recording medium.

The storage 3e stores a plurality of recipes. The recipe is information that specifies the details of processing, processing conditions and processing procedures of the substrate W. A plurality of recipes differ from each other in at least one of the details of processing, the processing conditions and the processing procedures of the substrate W. The controller 3 controls the substrate processing apparatus 1 such that the substrate W is processed according to the recipe designated by the host computer. The controller 3 is programmed to execute the individual steps described below.

Next, an example of processing of the substrate W will be described.

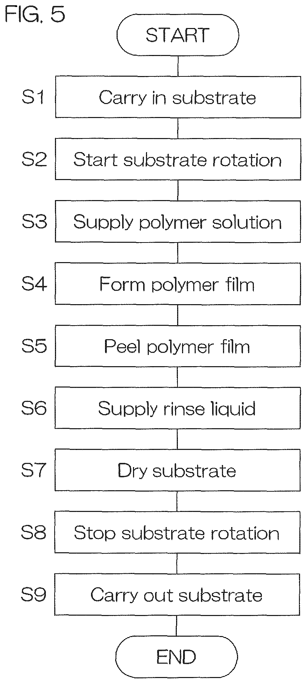

FIG. 5 is a process chart for describing an example of processing of the substrate W performed by the substrate processing apparatus 1. In the following, reference is made to FIGS. 2 and 5.

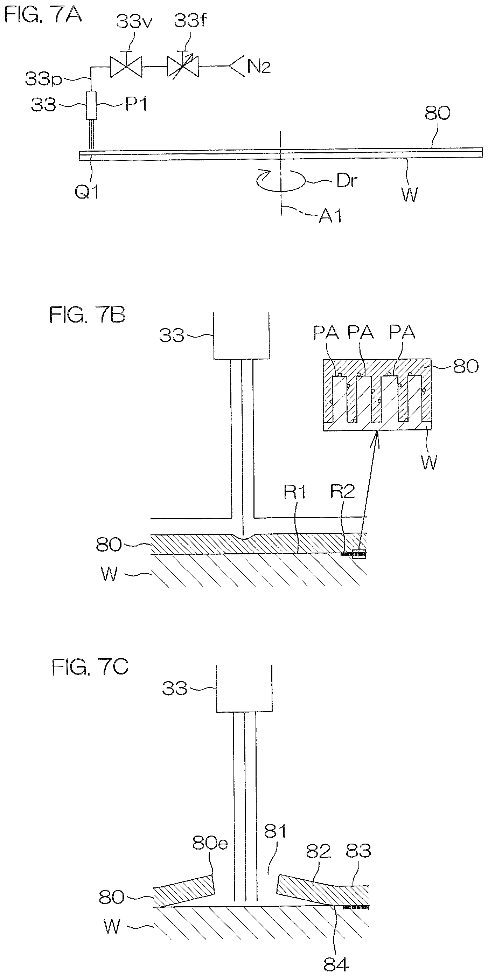

The substrate W to be processed is a semiconductor wafer such as silicon wafer, for example. The substrate W may be a substrate W having a pattern PA (see FIG. 7B) formed on the front surface of the substrate W, or it may be a substrate W without a pattern PA formed on the front surface of the substrate W.

When a substrate W is processed by the substrate processing apparatus 1, a carry-in step (step S1 of FIG. 5) is performed in which the substrate W is carried into the chamber 4.

Specifically, with all of the guards 24 disposed at the lower position and all of the scan nozzles disposed at the standby position, the center robot CR (see FIG. 1A) horizontally supports the substrate W with the hand Hc while causing the hand Hc to enter into the chamber 4. The center robot CR then places the substrate W on the hand Hc onto the plurality of chuck pins 11, with the front surface of the substrate W facing upward. The center robot CR then causes the hand Hc to retract from inside the chamber 4.

After the substrate W has been placed on the plurality of chuck pins 11, the plurality of chuck pins 11 are pressed against the edge of the substrate W, thereby the substrate W is held. The spin motor 14 is then actuated to start rotation of the substrate W (step S2 in FIG. 5). Thereby, the substrate W rotates at the polymer solution supply rate. Before or after rotation of the substrate W starts, the guard raising/lowering unit 27 causes one or more of the guards 24 to rise from the lower position to the upper position.

This step is followed by a polymer solution supply step in which the polymer solution is supplied onto the upper surface of the substrate W (step S3 of FIG. 5).

Specifically, the nozzle-moving unit 31m moves the polymer solution nozzle 31 from the standby position to the processing position, with one or more of the guards 24 disposed at the upper position. The polymer solution valve 31v is then opened and the polymer solution nozzle 31 starts discharge of the polymer solution. When a prescribed time period has elapsed after the polymer solution valve 31v has been opened, the polymer solution valve 31v is closed and discharge of the polymer solution is stopped. The nozzle-moving unit 31m then moves the polymer solution nozzle 31 to the standby position.

The polymer solution that has been discharged from the polymer solution nozzle 31 flows outward along the upper surface of the substrate W by centrifugal force after having hit the upper surface of the substrate W that is rotating at the polymer solution supply rate, and scatters from the outer perimeter of the substrate W to the area around the substrate W. This causes the polymer solution to be supplied over the entire region on the upper surface of the substrate W, so that a liquid film of the polymer solution is formed over the entire region of the upper surface of the substrate W. When the polymer solution nozzle 31 discharges the polymer solution, the nozzle-moving unit 31m may move the hit position of the polymer solution on the upper surface of the substrate W so that the hit position passes through the central portion and the outer peripheral portion, or it may stop the hit position at the central portion. The decision of whether or not to move the hit position also applies for the processing liquid supplied to the upper surface of the substrate W after the polymer solution.

A polymer film forming step (step S4 in FIG. 5) is then carried out, in which the liquid film of the polymer solution on the substrate W is converted to a solid or semi-solid polymer film 80 (see FIG. 7A).

Specifically, the spin motor 14 keeps the rotational speed of the substrate W at the film-forming rate while one or more guards 24 are disposed at the upper position and with the polymer solution nozzle 31 stopping discharge of the polymer solution. The film-forming rate may be the same as or different from the polymer solution supply rate. The polymer solution on the substrate W is still discharged outward from the substrate W by centrifugal force even after discharge of the polymer solution has been stopped. The thickness of the liquid film of the polymer solution on the substrate W therefore decreases. When the polymer solution on the substrate W has been discharged to some degree, the amount of discharge of the polymer solution from the substrate W per unit time decreases to zero or approximately zero. This stabilizes the thickness of the liquid film of the polymer solution on the substrate W to a value corresponding to the rotational speed of the substrate W, while the entire region of the upper surface of the substrate W is covered with the liquid film of the polymer solution.

While the spin motor 14 is rotating the substrate W at the film-forming rate, the heating fluid valve 71v is opened and the lower surface nozzle 71 starts discharge of hot water. After having hit the lower surface of the substrate W that is rotating at the film-forming rate, the hot water discharged from the lower surface nozzle 71 flows outward along the lower surface of the substrate W. The hot water is thereby supplied to the entire region of the lower surface of the substrate W. When a prescribed time period has elapsed after the heating fluid valve 71v has been opened, the heating fluid valve 71v is closed and discharge of the hot water is stopped. Discharge of the hot water may be initiated before discharge of the polymer solution is stopped, or before discharge of the polymer solution has started.

The concentration of the solvent of the polymer solution on the substrate W (the water concentration, if the polymer solution is a water-soluble polymer solution) gradually decreases due to evaporation of the solvent. Since the spin motor 14 is rotating the substrate W, a gas stream that promotes evaporation of the solvent forms above the substrate W. Downflow of clean air flowing from the FFU 6 (see FIG. 2) also promotes evaporation of the solvent. In addition, the heat supplied from the hot water to the substrate W, which is transmitted to the polymer solution, further promotes evaporation of the solvent. While the solvent is evaporating from the polymer solution there is no or virtually no evaporation of the polymer as the solute. Evaporation of the solvent from the polymer solution therefore causes gradual increase in the polymer concentration in the polymer solution.

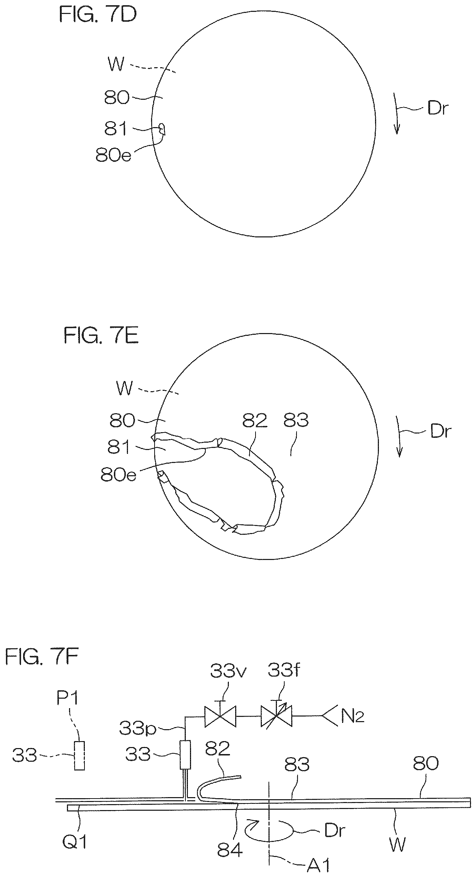

When the polymer concentration reaches at least the saturation concentration, the liquid film of the polymer solution covering the entirety of the upper surface of the substrate W is converted to a solid or semi-solid polymer film 80 covering the entirety of the upper surface of the substrate W, with the upper surface of the substrate W in a dried or almost dried state. Viewing the upper surface of the substrate W from the vertical direction, the polymer film 80 is circular with a diameter equal to that of the substrate W, and concentric with the substrate W (see FIG. 7D). When the upper surface of the substrate W is viewed from the vertical direction, the outer edge of the polymer film 80 overlaps with the outer edge of the substrate W at all locations. The polymer film 80 is peeled from the substrate W by the pressure of the peeling gas, as described below. If the polymer film 80 peeled from the substrate W does not separate, the polymer film 80 may be in a high-solvent state such as a gel.

When the liquid film of the polymer solution is converted to the polymer film 80, the particles contacting the liquid film of the polymer solution are captured by the polymer film 80, restricting movement with respect to the polymer film 80. Supply of the hot water to the lower surface of the substrate W continues even after the polymer film 80 has been formed. This results in further evaporation of the solvent from the polymer film 80, thus shrinking the polymer film 80. The shrinkage force of the polymer film 80 tends to cause peeling of the particles incorporated into the polymer film 80 from the substrate W. As a result, unwanted matter such as particles peel from the substrate W or become easier to peel from the substrate W.

This step is followed by a polymer film peeling step (step S5 in FIG. 5) in which the polymer film 80 is peeled from the substrate W by discharge of peeling gas toward the upper surface of the substrate W.

Specifically, the nozzle-moving unit 33m moves the peeling gas nozzle 33 from the standby position to the processing position, with one or more of the guards 24 disposed at the upper position and with the spin motor 14 rotating the substrate W at the peel rate. The open/close valve 33v is then opened and the peeling gas nozzle 33 starts discharge of peeling gas. When a prescribed time period has elapsed after the open/close valve 33v has been opened, the open/close valve 33v is closed and discharge of the peeling gas is stopped. The nozzle-moving unit 33m then moves the peeling gas nozzle 33 to the standby position. The peel rate may be the same as or different from the polymer solution supply rate. As explained below, when the peeling gas nozzle 33 discharges the peeling gas toward the upper surface of the substrate W that is covered by the polymer film 80, the polymer film 80 adhering over the entirety of the upper surface of the substrate W peels from the substrate W and is removed from the substrate W.

Next, a rinse liquid supply step (step S6 in FIG. 5) is carried out in which purified water as an example of the rinse liquid is supplied onto the upper surface of the substrate W.

Specifically, the nozzle-moving unit 32m moves the rinse liquid nozzle 32 from the standby position to the processing position, with one or more of the guards 24 disposed at the upper position. The rinse liquid valve 32v is then opened and the rinse liquid nozzle 32 starts discharge of purified water while the spin motor 14 is rotating the substrate W at the rinse liquid supply rate. Before discharge of the purified water starts, the guard raising/lowering unit 27 may move one or more of the guards 24 vertically in order to switch the guard 24 that receives the liquid discharged from the substrate W.

The purified water that has been discharged from the rinse liquid nozzle 32 flows outward along the upper surface of the substrate W by centrifugal force after having hit the upper surface of the substrate W that is rotating at the rinse liquid supply rate, and scatters from the outer perimeter of the substrate W to the area around the substrate W. This causes a liquid film of the purified water to be formed covering the entirety of the upper surface of the substrate W. When unwanted matter such as fragments of the polymer film 80 remain on the substrate W, the unwanted matter is washed away by the purified water. When a prescribed time period has elapsed after the rinse liquid valve 32v has been opened, the rinse liquid valve 32v is closed and discharge of the purified water is stopped. Therefore, the nozzle-moving unit 32m moves the rinse liquid nozzle 32 to the standby position.

Next, a drying step is carried out in which the substrate W is dried by high-speed rotation of the substrate W (step S7 of FIG. 5).

Specifically, the spin motor 14 accelerates the substrate W in the rotational direction Dr (see FIG. 7A), rotating it at a higher rotational speed (for example, several thousand rpm) than the rotational speed of the substrate W from the polymer solution supply step to the rinse liquid supply step. When the spin motor 14 starts high-speed rotation of the substrate W, the liquid scatters out from the substrate W and is removed from the substrate W, thereby drying the substrate W. When a prescribed time period has elapsed after initiating high-speed rotation of the substrate W, the spin motor 14 stops the rotation. This stops rotation of the substrate W (step S8 of FIG. 5).

This is followed by a carry-out step in which the substrate W is carried out from the chamber 4 (step S9 of FIG. 5).

Specifically, the guard raising/lowering unit 27 lowers all of the guards 24 to the lower position. Thereafter, the center robot CR causes the hand Hc to enter into the chamber 4. After gripping of the substrate W by the plurality of chuck pins 11 has been released, the center robot CR supports the substrate W on the spin chuck 10 by the hand Hc. The center robot CR then retracts the hand Hc from inside the chamber 4 while supporting the substrate W horizontally with the hand Hc. Thereby, the processed substrate W is carried out from the chamber 4.

Next, the polymer film peeling step will be explained in greater detail.

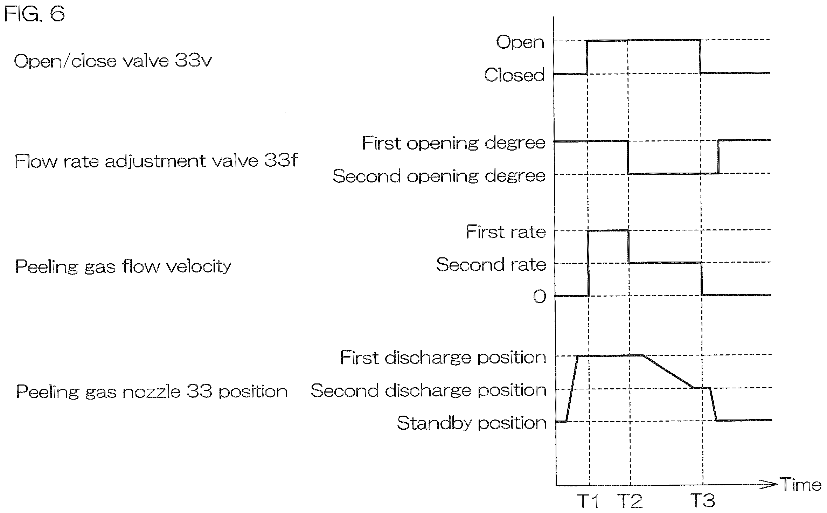

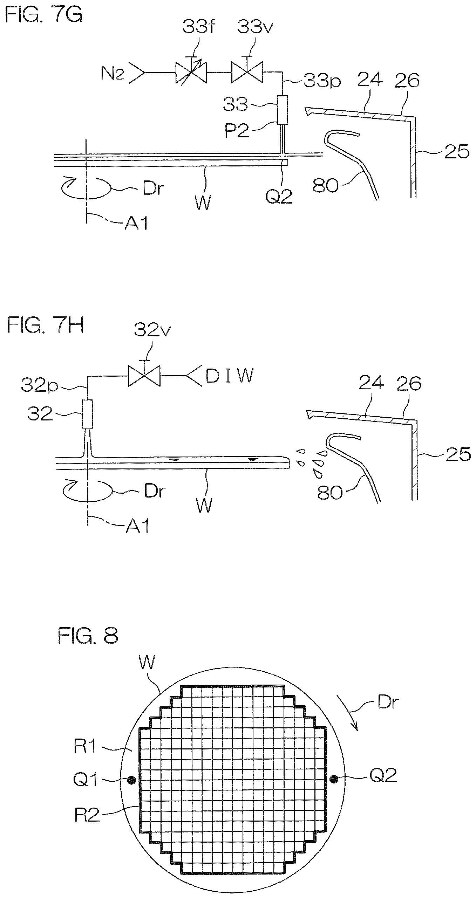

FIG. 6 is a time chart showing an example of change in flow velocity of the peeling gas when carrying out a polymer film peeling step. FIG. 7A to FIG. 7G are schematic diagrams showing the substrate W while carrying out a polymer film peeling step. FIG. 7H is a schematic diagram showing the state of a substrate W while carrying out a rinse liquid supply step. FIG. 8 is a schematic plan view of a substrate W showing a non-device-forming region R1 and device-forming regions R2. The plurality of circles inside the rectangular frame in FIG. 7B represent particles. The following explanation refers to FIG. 2.

In the polymer film peeling step, the nozzle actuator 33a moves the peeling gas nozzle 33 from the standby position to the first discharge position P1 (see FIG. 7A), with one or more of the guards 24 disposed at the upper position and with the spin motor 14 rotating the substrate W at the peel rate. As shown in FIG. 6, at time T1, while the peeling gas nozzle 33 is located at the first discharge position P1, the open/close valve 33v is opened and the peeling gas nozzle 33 starts discharge of the peeling gas. While the open/close valve 33v is open, the opening degree of the flow rate adjustment valve 33f is the first opening degree, and the flow velocity of peeling gas discharged from the peeling gas nozzle 33 is the first rate.

As shown in FIG. 6, at time T2, the opening degree of the flow rate adjustment valve 33f is reduced from the first opening degree to the second opening degree. This causes the flow velocity of the peeling gas discharged from the peeling gas nozzle 33 to fall from the first rate to the second rate. The nozzle actuator 33a then moves the peeling gas nozzle 33 from the first discharge position P1 to the second discharge position P2. At time T3, the open/close valve 33v is then closed and the peeling gas nozzle 33 stops discharge of the peeling gas. The nozzle actuator 33a then moves the peeling gas nozzle 33 from the second discharge position P2 to the standby position. After the open/close valve 33v has closed, the opening degree of the flow rate adjustment valve 33f returns to the first opening degree.

As shown in FIG. 7A, the peeling gas discharged from the peeling gas nozzle 33 hits the polymer film 80 at the hit position and then radially flows from the hit position along the front surface of the polymer film 80. The hit position is a circular region where the peeling gas discharged from the peeling gas nozzle 33 first hits the upper surface of the substrate W or the upper surface of the polymer film 80. The diameter of the hit position is smaller than the radius of the substrate W. The diameter of the hit position may be equal to or less than the outer diameter of the peeling gas nozzle 33, or it may be greater than the outer diameter of the peeling gas nozzle 33. The diameter of the hit position may be a value allowing the entire hit position to fit within the non-device-forming region R1 (see FIG. 8), or it may be a different value. The hit position may also be a non-circular region, such as a linear region.

The force applied from the peeling gas to the polymer film 80 is highest at the hit position. The polymer film 80 is pressed against the substrate W by the pressure of the peeling gas. As shown in FIG. 7B, the thickness of the polymer film 80 is locally decreased at the hit position. As shown in FIG. 7C, the peeling gas tears the polymer film 80 at the hit position and forms a through-hole 81 that penetrates through the polymer film 80 in the thickness direction of the polymer film 80. The through-hole 81 is a hole surrounded by an edge 80e of the polymer film 80. The edge 80e of the polymer film 80 corresponds to the outer perimeter of the through-hole 81. The through-hole 81 may be surrounded by the polymer film 80 around the entire perimeter of the through-hole 81, and it may be opened by the outer edge of the polymer film 80.

As shown in FIG. 7A, the peeling gas nozzle 33 starts to discharge the peeling gas while being stationary at the first discharge position P1 where the peeling gas is blown onto the upper surface of the substrate W between the center of the substrate W and the outer perimeter of the substrate W. Since the peeling gas nozzle 33 is stationary, the absolute position of the peeling gas nozzle 33 does not change while the substrate W rotates, and therefore the hit position on the upper surface of the substrate W rotates with respect to the substrate W around the rotational center of the substrate W. The thickness of the polymer film 80 therefore decreases locally within a circle that is concentric with the substrate W. A through-hole 81 forms as the thickness of the polymer film 80 decreases to some extent within the circle. The through-hole 81 may be a linear slit extending in the circumferential direction of the substrate W.

As shown in FIG. 7C, formation of the through-hole 81 in the polymer film 80 causes a portion of the upper surface of the substrate W to be exposed from the polymer film 80 at the through-hole 81. The polymer film 80 is also peeled from the substrate W around the through-hole 81, forming a gap between the polymer film 80 and the substrate W. In other words, the polymer film 80 changes from a state of adhering to the entirety of the upper surface of the substrate W to a state of being partially peeled from the upper surface of the substrate W. As a result, the polymer film 80 is morphologically divided into a peeled portion 82 that is peeled from the upper surface of the substrate W and an adhering portion 83 that is adhered to the upper surface of the substrate W. In other words, the polymer film 80 changes from a state in which the entire polymer film 80 is the adhering portion 83, to a state which includes the peeled portion 82 and the adhering portion 83.

The polymer film 80 is teared by the pressure of the peeling gas so that the polymer film 80 now has the peeled portion 82 that has peeled from the upper surface of the substrate W and the adhering portion 83 that is adhered to the upper surface of the substrate W which is integral with the peeled portion 82. The peeled portion 82 is one portion of the polymer film 80, while the adhering portion 83 is the remaining portion of the polymer film 80. The lower surface of the adhering portion 83 is adhered to the upper surface of the substrate W. The upper surface of the adhering portion 83 is in contact with the atmosphere in the space in which the substrate W is set. The upper surface of the adhering portion 83 is continuous with the upper surface of the peeled portion 82, while the lower surface of the adhering portion 83 is also continuous with the lower surface of the peeled portion 82. The peeled portion 82 is all or a portion of the polymer film 80 whose bonding with the substrate W has been severed. After peeling from the substrate W, the peeled portion 82 may be in contact with the upper surface of the substrate W or separate from the upper surface of the substrate W.

Immediately after the through-hole 81 has formed, the polymer film 80 is closely adhering to most of the upper surface of the substrate W, with the polymer film 80 peeled only from a very narrow region around the through-hole 81. The peeling gas enters through the through-hole 81, between the polymer film 80 and the substrate W, and peeling force is applied to the polymer film 80, causing the polymer film 80 to peel from the substrate W. The polymer film 80 is further peeled from the substrate W due to this peeling force. Specifically, the peeling gas that has entered between the polymer film 80 and the substrate W presses at the boundary 84 between the peeled portion 82 and the adhering portion 83 (see FIG. 7C) in the direction of the adhering portion 83, thereby forming a new peeled portion 82. Strictly, the adhering portion 83 changes to be a new peeled portion 82.

The peeling gas that has entered through the through-hole 81 between the polymer film 80 and the substrate W spreads in a semicircular fashion from the outer perimeter of the through-hole 81. Therefore, a new semicircular peeled portion 82 with its center disposed near the outer perimeter of the through-hole 81 is formed on the outside of the through-hole 81. Immediately after the through-hole 81 has formed, a plurality of such semicircular peeled portions 82 are formed around the entire perimeter or roughly the entire perimeter of the through-hole 81, the plurality of semicircular peeled portions 82 are linked together. Immediately after the through-hole 81 has formed, therefore, an annular peeled portion 82 is formed, spreading outward from the entire perimeter or roughly the entire perimeter of the through-hole 81.

After the annular peeled portion 82 surrounding the through-hole 81 has formed, the peeling gas that has entered between the polymer film 80 and the substrate W spreads in a semicircular manner from the outer perimeter of the annular peeled portion 82. At least one new semicircular peeled portion 82 is thus formed on the outside of the annular peeled portion 82. Repetition of the same phenomenon causes the adhering portion 83 to convert to the peeled portion 82, thereby increasing the peeled portion 82. When the area of the peeled portion 82 is greater than the area of the adhering portion 83, and the entire adhering portion 83 is converted to the peeled portion 82, the entire polymer film 80 is peeled from the upper surface of the substrate W.

FIG. 7D shows a through-hole 81 immediately after its formation. The peeling gas hits the polymer film 80 between the center of the substrate W and the outer perimeter of the substrate W. When the through-hole 81 is not open at the outer perimeter of the substrate W and is surrounded by the polymer film 80, the peeled portion 82 spreads from the through-hole 81 to the outer perimeter of the substrate W on the side of the through-hole 81 opposite from the center of the substrate W. This results in peeling of the polymer film 80 from a portion of the outer perimeter of the substrate W. When the peeled portion 82 has not reached the outer perimeter of the substrate W, the peeled portion 82 may be widened to the outer perimeter of the substrate W by moving the peeling gas nozzle 33 such that the peeling gas nozzle 33 moves away from the center of the substrate W.

FIG. 7E shows a through-hole 81 that has increased from its initial size. The force causing rotation of the substrate W presses the polymer film 80 in the rotational direction Dr of the substrate W against the gas that has entered between the polymer film 80 and the substrate W. In other words, the force causing rotation of the substrate W tends to widen the peeled portion 82 in the direction opposite from the rotational direction Dr of the substrate W. As shown in FIG. 7E, the peeled portion 82 widens in the opposite direction from the rotational direction Dr of the substrate W at a higher rate than the speed at which the peeled portion 82 widens in the rotational direction Dr of the substrate W. The polymer film 80 therefore peels from the substrate W not only by the pressure of the peeling gas but also by the force causing rotation of the substrate W. This accelerates peeling of the polymer film 80.

The peeling gas nozzle 33 starts to discharge the peeling gas at the first discharge position P1 where the peeling gas is blown onto the upper surface of the substrate W between the center of the substrate W and the outer perimeter of the substrate W. The nozzle actuator 33a then horizontally moves the peeling gas nozzle 33, which is located at the first discharge position P1, to the second discharge position P2 (see FIG. 7G), thereby changing the distance from the center of the substrate W to the hit position of the peeling gas. FIG. 7F shows the peeling gas nozzle 33 moving toward the second discharge position P2. Regardless of the position of the peeling gas nozzle 33 in the path from the first discharge position P1 to the second discharge position P2, the peeling gas discharged from the peeling gas nozzle 33 is blown onto the upper surface of the substrate W either through the polymer film 80 or without the polymer film 80.

When the peeling gas nozzle 33 is disposed at the first discharge position P1 indicated by the dash-dot-dot line in FIG. 7F, the peeling gas discharged from the peeling gas nozzle 33 first hits the first hit location Q1 within the upper surface of the substrate W, and then radially flows from the first hit location Q1 along the upper surface of the substrate W. Likewise, when the peeling gas nozzle 33 is disposed at the second discharge position P2 shown in FIG. 7G, the peeling gas discharged from the peeling gas nozzle 33 first hits the second hit location Q2 within the upper surface of the substrate W, and then radially flows from the second hit location Q2 along the upper surface of the substrate W.

The first discharge position P1 is the position where the peeling gas is blown onto or near the outer perimeter of the substrate W. The second discharge position P2 may be the center location where the peeling gas is blown onto or near the center of the substrate W, it may be the outer perimeter location where the peeling gas is blown onto or near the outer perimeter of the substrate W, or it may be an intermediate location between the center location and the outer perimeter location. The nozzle actuator 33a may also reciprocally move the peeling gas nozzle 33 one or more times horizontally between the two locations, i.e., the first discharge position P1 and second discharge position P2.

The nozzle actuator 33a may maintain the traveling speed of the peeling gas nozzle 33 constant or change it. In the latter case, the nozzle actuator 33a may move the peeling gas nozzle 33 so as to produce at least one of an acceleration period, a deceleration period and a resting period, or may move the peeling gas nozzle 33 so as to produce a constant speed period, and at least one of an acceleration period, a deceleration period, a resting period.

An acceleration period is a period in which the traveling speed of the peeling gas nozzle 33 increases stepwise or continuously as the hit position of the peeling gas approaches the center of the substrate W. A deceleration period is a period in which the traveling speed of the peeling gas nozzle 33 decreases stepwise or continuously as the hit position of the peeling gas approaches the center of the substrate W. A resting period is a period in which the peeling gas nozzle 33 is stationary. A constant speed period is a period in which the peeling gas nozzle 33 moves at a constant speed.

As shown in FIG. 7F, when the peeling gas nozzle 33 moves from the first discharge position P1, the hit position of the peeling gas with respect to the substrate W approaches the center of the substrate W, while approaching the boundary 84 between the peeled portion 82 and the adhering portion 83. This causes the pressure of the peeling gas to increase at the boundary 84 between the peeled portion 82 and the adhering portion 83, resulting in further peeling of the polymer film 80. In other words, a new peeled portion 82 is formed, and the peeled portion 82 widens in the direction of the center of the substrate W. The peeling gas that has entered between the polymer film 80 and the substrate W flows from the new peeled portion 82 in the center direction (the direction toward the center of the substrate W) and the circumferential direction of the substrate W. As shown in FIG. 7E, this phenomenon occurs as the hit position of the peeling gas approaches the center of the substrate W, the peeled portion 82 increases in the center direction and the circumferential direction of the substrate W.

When the peeling gas nozzle 33 moves from the first discharge position P1, a force acts from the peeling gas to the polymer film 80, which spreads the edge 80e of the polymer film 80 forming the through-hole 81, and this can sometimes rip the edge 80e of the polymer film 80. In this case, one or more slits opening at the edge 80e of the polymer film 80 are formed in the polymer film 80. As shown in FIG. 7E, when a plurality of slits are formed in the polymer film 80, the peeled portion 82 at a location between two slits is turned up from the substrate W, and may land on the adhering portion 83 with the front surface and rear surface inverted. The peeling gas is blown onto the inverted peeled portion 82 on the adhering portion 83, applying force to the peeled portion 82. The force is transmitted to the adhering portion 83 through the peeled portion 82, further peeling off the polymer film 80. This further increases the size of the peeled portion 82.

As shown in FIG. 7G, when the peeling gas is discharged toward the upper surface of the substrate W while moving the hit position of the peeling gas with respect to the substrate W, the entire adhering portion 83 is converted to the peeled portion 82, and the entire polymer film 80 are peeled from the substrate W. The polymer film 80 may peel from the substrate W with the entire polymer film 80 being connected, or it may peel from the substrate W as a plurality of fragments. Discharge of the peeling gas and rotation of the substrate W continue even after the entire polymer film 80 has peeled from the substrate W. The polymer film 80 that remains on the substrate W after peeling from the substrate W scatters from the substrate W due to force from either or both the peeling gas and substrate W. As a result, the particle-holding polymer film 80 is removed from the substrate W.

As shown in FIG. 7H, after the polymer film 80 has been removed from the substrate W, the substrate W rotates while a rinse liquid such as purified water is discharged toward the upper surface of the substrate W (rinse liquid supply step). When unwanted matter such as fragments of the polymer film 80 remain on the substrate W, the unwanted matter is washed off by the rinse liquid and scatters around the substrate W from the outer perimeter of the substrate W, together with the rinse liquid. After the rinse liquid scattered from the substrate W has been received by the inner peripheral surface of the guard 24, it flows downward along the inner peripheral surface of the guard 24. The rinse liquid then enters into the cup 23 (see FIG. 2) and is discharged from the cup 23 through a drainage hole in the cup 23.

When a through-hole 81 has been formed in the polymer film 80, the polymer film 80 may be torn off, resulting in generation of fragments of the polymer film 80. Fragments of the polymer film 80 are sometimes produced when the peeled portion 82 spreads out from the through-hole 81, or even when a linear slit opened at the edge 80e of the polymer film 80 has formed in the polymer film 80. Such fragments of the polymer film 80 are subjected to force from the peeling gas or the rotating substrate W, and scatter to the inner peripheral surface of the guard 24. When fragments of the polymer film 80 remain on the substrate W, the fragments are washed off by the rinse liquid and removed from the substrate W, resulting in removal of the fragments of the polymer film 80 from the substrate W.

The polymer film 80 that has scattered from the substrate W after peeling from the substrate W is received by the inner peripheral surface of the guard 24, and then falls downward through the space inside the guard 24. When the polymer film 80 that has scattered from the substrate W remains inside the guard 24 without falling to the cup 23, the polymer film 80 contacts with the rinse liquid that has scattered from the substrate W, dissolving in the rinse liquid. This causes the polymer film 80 to be reduced in size or split into numerous fragments, which fall into the interior of the cup 23. After the polymer film 80 in the cup 23 has dissolved in the rinse liquid in the cup 23 or has been further converted to small fragments by contact with the rinse liquid, it is discharged from the cup 23, together with the rinse liquid, through the drainage hole of the cup 23.

As shown in FIG. 6, after the peeling gas nozzle 33 has started to discharge the peeling gas at the first discharge position P1, the opening degree of the flow rate adjustment valve 33f is the first opening degree. When a prescribed time period has elapsed after the open/close valve 33v has been opened, the opening degree of the flow rate adjustment valve 33f is reduced from the first opening degree to the second opening degree. This causes a decrease in the flow rate of the peeling gas supplied to the peeling gas nozzle 33, resulting in reduction of the pressure applied by the peeling gas on the upper surface of the substrate W, from a first pressure to a second pressure. After the opening degree of the flow rate adjustment valve 33f has decreased from the first opening degree to the second opening degree, the nozzle actuator 33a moves the peeling gas nozzle 33 from the first discharge position P1 to the second discharge position P2. The hit position of the peeling gas therefore moves with respect to the substrate W within the upper surface of the substrate W in state where the pressure applied by the peeling gas to the upper surface of the substrate W is reduced.

When the through-hole 81 has formed in the polymer film 80, the opening degree of the flow rate adjustment valve 33f is the first opening degree which is larger than the second opening degree, and the pressure applied by the peeling gas to the upper surface of the substrate W is the first pressure which is greater than the second pressure. It is thus possible to more reliably form a through-hole 81 in a shorter period of time compared to the case where the pressure applied by the peeling gas to the upper surface of the substrate W is the second pressure. On the other hand, when the hit position of the peeling gas is moving with respect to the upper surface of the substrate W, the opening degree of the flow rate adjustment valve 33f is the second opening degree. Since the peeling gas is present between the polymer film 80 and the substrate W after the through-hole 81 has formed in the polymer film 80, the polymer film 80 can be peeled by the pressure of the peeling gas even if the pressure applied by the peeling gas to the upper surface of the substrate W is lowered. Therefore, this allows the peeled portion 82 to be widened while reducing consumption of the peeling gas, compared to the case where the pressure applied by the peeling gas to the upper surface of the substrate W is maintained at the first pressure.

The polymer film peeling step may be carried out after a device such as a transistor or a pattern PA (see FIG. 7B) has been formed in the substrate W, or it may be carried out before the device or pattern PA has been formed in the substrate W. In the former case, as shown in FIG. 8, the first discharge position P1 of the peeling gas nozzle 33 may be set so that the first hit location Q1 where the peeling gas first hits the substrate W is located within the non-device-forming region R1.

The device-forming region R2 and non-device-forming region R1 are both regions within the front surface of the substrate W that corresponds to the device-forming surface. FIG. 8 shows the outer edge of the device-forming region R2 as a bold line. The device-forming region R2 is the region where the device, such as a transistor, and the pattern PA are formed. The non-device-forming region R1 is the region where the device and pattern PA are not formed, the non-device-forming region R1 is an annular region around the device-forming region R2. The first hit location Q1 may be located within the device-forming region R2, while the second hit location Q2 may be located within the device-forming region R2 or within the non-device-forming region R1. FIG. 8 shows an example of the latter case.

When the first hit location Q1 is located within the non-device-forming region R1, the peeling gas at relatively high-pressure hits the non-device-forming region R1. As mentioned above, after the opening degree of the flow rate adjustment valve 33f has decreased from the first opening degree to the second opening degree, the nozzle actuator 33a moves the peeling gas nozzle 33 from the first discharge position P1 to the second discharge position P2. Consequently, the hit position of the peeling gas, with respect to the upper surface of the substrate W, moves from the non-device-forming region R1 to the device-forming region R2, with a state of lower pressure of the peeling gas hitting the non-device-forming region R1. This allows the polymer film 80 to peel with a state of lower force applied from to the device-forming region R2 from the peeling gas.

Next, the effect of this preferred embodiment will be described.

For this preferred embodiment, the peeling gas is discharged from the peeling gas nozzle 33, at the relatively high first rate, toward the upper surface of the substrate W covered by the solid or semi-solid polymer film 80. Because the rate of peeling gas is relatively high, relatively large pressure is applied from the peeling gas onto the polymer film 80, causing the polymer film 80 to rip, and thus separating apart the peeled portion 82 and the adhering portion 83. The peeling gas then enters between the peeled portion 82 and the substrate W. The peeling gas is subsequently discharged from the peeling gas nozzle 33 at the relatively low second rate. The boundary 84 between the peeled portion 82 and the adhering portion 83 is pushed in the direction of the adhering portion 83 by the peeling gas that has entered between the peeled portion 82 and substrate W. As a result, the adhering portion 83 peels from the substrate W and is converted to a peeled portion 82.

The nozzle actuator 33a horizontally moves the peeling gas nozzle 33, thereby changing the distance from the hit position of the peeling gas to the center of the substrate W, relative to the upper surface of the substrate W. The force applied from the peeling gas to the polymer film 80 is highest at the hit position. By moving the peeling gas nozzle 33 horizontally, it is thus possible to accelerate conversion from the adhering portion 83 to the peeled portion 82.

The polymer film 80 is thus peeled from the substrate W due to the peeling gas and nozzle actuator 33a. Therefore, it is possible to peel the polymer film 80 from the substrate W without using a liquid such as a peeling liquid. Furthermore, since the peeling gas is discharged at the relatively high first rate, it is possible to reliably rip the polymer film 80 in a shorter period of time. Since the flow velocity of the peeling gas is lowered to the second rate after the polymer film 80 has been ripped, the amount of peeling gas used may be reduced compared to the case where the flow velocity of the peeling gas continues to be kept at the first rate. Therefore, it is possible to reduce energy consumption required to process the substrate W.

For this preferred embodiment, the peeling gas nozzle 33 located at the first discharge position P1 discharges the peeling gas at the first rate. The first discharge position P1 is the position where the peeling gas discharged from the peeling gas nozzle 33 hits the non-device-forming region R1 within the upper surface of the substrate W. Consequently, it is possible to rip the polymer film 80 by the pressure of the peeling gas, while preventing the pressure of the peeling gas from applying onto either or both the device and pattern PA formed in the device-forming region R2.

The nozzle actuator 33a moves the peeling gas nozzle 33 to the second discharge position P2 after the flow velocity of the peeling gas has been reduced to the second rate. The position between the first discharge position P1 and the second discharge position P2 is the position where the peeling gas discharged from the peeling gas nozzle 33 hits the device-forming region R2 within the upper surface of the substrate W. Consequently, it is possible to further peel the polymer film 80 from the substrate Wwhile preventing application of strong force onto either or both the device and pattern PA formed in the device-forming region R2.

For this preferred embodiment, the rinse liquid is discharged toward the upper surface of the substrate W after the polymer film 80 has been peeled from the upper surface of the substrate W. When the polymer film 80 itself or small fragments of the polymer film 80 remain on the upper surface of the substrate W, the polymer film 80 on the substrate W is washed off by the rinse liquid. The polymer film 80 is a solid or semi-solid film including a water-soluble polymer. The rinse liquid is a water-containing liquid. Even if the polymer film 80 remains on the substrate W without being washed off by the rinse liquid, the polymer film 80 is dissolved in the rinse liquid and is discharged from the substrate W together with the rinse liquid. This can decrease the amount of polymer film 80 accumulating on the upper surface of the substrate W.

For this preferred embodiment, the polymer film 80 that peels from the upper surface of the substrate W by the pressure of the peeling gas and scatters around the substrate W from the upper surface of the substrate W to the area around the substrate W, is received by the guard 24 disposed around the substrate W. Likewise, the rinse liquid that is supplied to the upper surface of the substrate W and has scattered around the substrate W from the upper surface of the substrate W to the area around the substrate W is received by the guard 24 disposed around the substrate W. When the polymer film 80 itself or small fragments of the polymer film 80 have accumulated inside the guard 24, the polymer film 80 contacts with the rinse liquid that has scattered from the substrate W and dissolves in the rinse liquid, thus allowing the polymer film 80 to be removed from inside the guard 24.

For this preferred embodiment, the solid or semi-solid film including the water-soluble polymer adheres to the upper surface of the substrate W at a water contact angle of 32° or greater. The water contact angle is one measure of the degree of hydrophilicity. Since the water contact angle is 32° or greater and the upper surface of the substrate W does not have high hydrophilicity, the affinity of the polymer film 80 for the upper surface of the substrate W is not high. The polymer film 80 is therefore easier to peel from the substrate W compared to the case where the polymer film 80 has high affinity for the upper surface of the substrate W. This can decrease the amount of fragments of the polymer film 80 that accumulate on the substrate W instead of peeling from the substrate W.

For this preferred embodiment, the polymer solution is discharged toward the upper surface of the substrate W, resulting in formation of a liquid film of the polymer solution on the substrate W. The heat of the heater 71h, as an example of a heat source, is transmitted to the liquid film. As a result, evaporation of the solvent is promoted and the liquid film of the polymer solution is converted to a solid or semi-solid polymer film 80. Moreover, evaporation of the solvent from the polymer solution generates force that causes shrinkage of the polymer film 80, so that particles incorporated into the polymer film 80 peel from the substrate W. When the polymer film 80 peels from the substrate W and is removed, the particles are also removed from the substrate W, thereby decreasing the amount of particles accumulating on the substrate W.

For this preferred embodiment, the peeling gas is discharged toward the upper surface of the substrate W, thereby causing the entire polymer film 80 to be peeled from the upper surface of the substrate W without having it separate. In other words, the entire polymer film 80 peels from the upper surface of the substrate W without producing fragments of the polymer film 80. The polymer film 80 that has peeled from the substrate W is torn but not fragmented. When the polymer film 80 that has peeled from the substrate W is removed, no fragments of the polymer film 80 remain on the substrate W. The entire polymer film 80 that has peeled from the substrate W can therefore be easily removed from the substrate W.

For this preferred embodiment, the peeling gas is discharged onto the peeling gas nozzle 33 at the first rate, after which the peeling gas is discharged onto the peeling gas nozzle 33 at the second rate. The peeling gas nozzle 33 is a variable opening nozzle that varies the opening area corresponding to the flow rate of peeling gas to be supplied to the peeling gas nozzle 33. Assuming a constant opening area of the peeling gas nozzle 33, i.e., a constant area of the discharge port of the peeling gas nozzle 33, the flow velocity of the peeling gas discharged from the discharge port of the peeling gas nozzle 33 will be directly proportional to the flow rate of the peeling gas supplied to the peeling gas nozzle 33.

When the flow rate of the peeling gas supplied to the peeling gas nozzle 33 is increased, the opening area of the peeling gas nozzle 33 decreases. Therefore, the flow velocity of peeling gas can be increased to a higher rate compared to the case where the opening area of the peeling gas nozzle 33 is constant, thus allowing increase in the pressure of the peeling gas applied to the substrate W and polymer film 80. Conversely, when the flow rate of the peeling gas supplied to the peeling gas nozzle 33 is decreased, the opening area of the peeling gas nozzle 33 increases. This can alleviate reduction in the pressure of the peeling gas generated at the discharge port of the peeling gas nozzle 33, allowing more efficient utilization of the energy of the peeling gas supplied to the peeling gas nozzle 33.

For this preferred embodiment, the peeling gas nozzle 33, as an example of a variable opening nozzle, includes the outer tube 34, the inner tube 35 and the elastic body 36. When the flow rate of the peeling gas supplied to the outer tube 34 increases to the first flow rate, the elastic body 36 undergoes elastic deformation to the first form. When the flow rate of the peeling gas decreases from the first flow rate to the second flow rate, the elastic body 36 returns to the second form. The first form is a form in which the inner tube 35 is inserted in the discharge port 34o of the outer tube 34 while the tip opening 35o of the inner tube 35 is disposed outside of the outer tube 34. The second form is a form in which the entire inner tube 35 is disposed inside the outer tube 34.

When the elastic body 36 is in the first form, the peeling gas supplied to the outer tube 34 exits from the tip opening 35o of the inner tube 35 through the peeling gas nozzle 33. When the elastic body 36 is in the second form, the peeling gas supplied to the outer tube 34 exits from the discharge port 34o of the outer tube 34 through the peeling gas nozzle 33. Thus, when the elastic body 36 is in the first form, the tip opening 35o of the inner tube 35 serves as the exit for peeling gas, the area of the tip opening 35o corresponds to the opening area of the peeling gas nozzle 33. When the elastic body 36 is in the second form, the discharge port 34o of the outer tube 34 serves as the exit for the peeling gas, the area of the discharge port 34o corresponds to the opening area of the peeling gas nozzle 33.

If the tip opening 35o of the inner tube 35 is not smaller than the discharge port 34o of the outer tube 34, the tip opening 35o of the inner tube 35 cannot pass through the discharge port 34o of the outer tube 34. Consequently, the opening area of the peeling gas nozzle 33, i.e., the area of the tip opening 35o of the inner tube 35, when the elastic body 36 is in the first form, is smaller than the opening area of the peeling gas nozzle 33, i.e., the discharge port 34o of the outer tube 34, when the elastic body 36 is in the second form. As a result, when the flow rate of the peeling gas supplied to the peeling gas nozzle 33 has increased, it is possible to reduce the opening area of the peeling gas nozzle 33, and when the flow rate of the peeling gas supplied to the peeling gas nozzle 33 has decreased, it is possible to increase the opening area of the peeling gas nozzle 33.

Next, other preferred embodiments will be described.

Instead of using the peeling gas nozzle 33, as an example of a variable opening nozzle, there may instead be used a first peeling gas nozzle that discharges the peeling gas at the first rate and a second peeling gas nozzle that discharges the peeling gas at the second rate.

When using a first peeling gas nozzle and a second peeling gas nozzle, the peeling gas may be discharged at the second rate by the second peeling gas nozzle toward the through-hole 81 formed in the polymer film 80 by discharge of the peeling gas by the first peeling gas nozzle at the first rate. Subsequently, the second peeling gas nozzle may be moved horizontally while discharging the peeling gas by the second peeling gas nozzle at the second rate.

In addition to or instead of contacting the lower surface of the substrate W with a high-temperature heating liquid higher than room temperature, a high-temperature heating gas higher than room temperature may be discharged toward the upper surface or lower surface of the substrate W to accelerate evaporation of the solvent of the polymer solution. In addition to or instead of transmitting the heat of a heating fluid to the polymer solution on the substrate W, the heat of a hot plate disposed between the lower surface of the substrate W and the upper surface 12u of the spin base 12 may be transmitted to the polymer solution on the substrate W. The hot plate is an example of a heat source.

In addition to or instead of transmitting the heat of the heat source directly or indirectly to the polymer solution on the substrate W, evaporation of the solvent of the polymer solution may be promoted by increasing the rotational speed of the substrate W. In addition to or instead of any one or more of the above, the air pressure in the space where the substrate W is disposed may be reduced to promote evaporation of the solvent of the polymer solution.

The substrate W may also be carried out from the chamber 4 without the rinse liquid supply step (step S6 of FIG. 5). The liquid film of the polymer solution may also be converted to the polymer film 80 without supplying a heating liquid such as hot water to the lower surface of the substrate W. When no rinse liquid is supplied and no heating liquid is supplied, the substrate W may be carried out from the chamber 4 without a drying step (step S7 of FIG. 5).

The substrate processing apparatus 1 is not restricted to an apparatus to process a disc-shaped substrate W, and may be an apparatus to process a polygonal substrate W.

Two or more arrangements among all the arrangements described above may be combined. Two or more steps among all the steps described above may be combined.

## Claims

1. A substrate processing apparatus (1) comprising:
a substrate holder (11, 12) that horizontally holds a substrate (W) having an upper surface covered with a solid or semi-solid polymer film (80),
one or more peeling gas nozzles (33) that tears the polymer film (80) by a pressure of a peeling gas such that a peeled portion (82) that has been peeled from the upper surface of the substrate (W) and an adhering portion (83) adhering to the upper surface of the substrate (W) are included in the polymer film (80) by discharging the peeling gas at a first rate toward the upper surface of the substrate (W) held by the substrate holder (11, 12), and then changes the adhering portion (83) to the peeled portion (82) with the peeling gas that has entered between the peeled portion (82) and the substrate (W) while discharging the peeling gas at a second rate which is slower than the first rate toward the upper surface of the substrate (W) held by the substrate holder (11, 12), and
a nozzle actuator (33a) that changes a distance from a hit position (Q1, Q2) of the peeling gas with respect to the upper surface of the substrate (W) to a center of the substrate (W) by moving the one or more peeling gas nozzles (33) horizontally.

2. The substrate processing apparatus (1) according to Claim 1, wherein the nozzle actuator (33a) positions the one or more peeling gas nozzles (33) at a first discharge position (P1) in which the peeling gas hits a non-device-forming region (R1) within the upper surface of the substrate (W) when the one or more peeling gas nozzles (33) are discharging the peeling gas at the first rate, and moves the one or more peeling gas nozzles (33) to a position in which the peeling gas hits a device-forming region (R2) within the upper surface of the substrate (W) when the one or more peeling gas nozzles (33) are discharging the peeling gas at the second rate.

3. The substrate processing apparatus (1) according to Claim 1, wherein:
the polymer film (80) is a solid or semi-solid film containing a water-soluble polymer, and
the substrate processing apparatus (1) further comprises a rinse liquid nozzle (32) that discharges rinse liquid containing water toward the upper surface of the substrate (W) held by the substrate holder (11, 12), after the polymer film (80) has been peeled from the upper surface of the substrate (W).

4. The substrate processing apparatus (1) according to Claim 3, further comprising a tubular guard (24) that receives the polymer film (80) and rinse liquid that have scattered around the substrate (W) from the upper surface of the substrate (W) held by the substrate holder (11, 12).

5. The substrate processing apparatus (1) according to any one of Claims 1 to 4, wherein:
the polymer film (80) is a solid or semi-solid film containing a water-soluble polymer, and
a water contact angle with respect to the upper surface of the substrate (W) is 32° or greater.

6. The substrate processing apparatus (1) according to any one of Claims 1 to 5, further comprising:
a polymer solution nozzle (31) that discharges a polymer solution toward the upper surface of the substrate (W) held by the substrate holder (11, 12), and
a heat source (71h) that generates heat to convert a liquid film of the polymer solution on the substrate (W) to the polymer film (80).

7. The substrate processing apparatus (1) according to any one of Claims 1 to 7, wherein the one or more peeling gas nozzles (33) discharge the peeling gas toward the upper surface of the substrate (W) held by the substrate holder (11, 12), until the entire polymer film (80) is peeled from the upper surface of the substrate (W) without being separated.

8. The substrate processing apparatus (1) according to any one of Claims 1 to 7, wherein:
the one or more peeling gas nozzles (33) are a single peeling gas nozzle (33) that discharges the peeling gas at the first rate and discharges the peeling gas at the second rate,
the substrate processing apparatus (1) further comprises a flow rate adjustment valve (33f) that varies the flow rate of the peeling gas supplied to the one peeling gas nozzle, and
the one peeling gas nozzle (33) is a variable opening nozzle an opening area of which decreases when a flow rate of the peeling gas supplied to the peeling gas nozzle increases and the opening area of which increases when the flow rate of the peeling gas supplied to the peeling gas nozzle decreases.

9. The substrate processing apparatus (1) according to Claim 8, wherein:
the variable opening nozzle includes an outer tube (34) including a discharge port that discharges the peeling gas, an inner tube (35) including a tip opening that discharges the peeling gas within the outer tube (34), and an elastic body (36) that supports the inner tube (35) within the outer tube (34), and
the elastic body (36) undergoes elastic deformation to a first form in which the tip opening of the inner tube (35) is disposed outside of the outer tube (34) while the inner tube (35) is inserted in the discharge port of the outer tube (34), when the flow rate of the peeling gas supplied within the outer tube (34) increases to the first flow rate, and returns to a second form in which the entire inner tube (35) is disposed in the outer tube (34), when the flow rate of the peeling gas supplied within the outer tube (34) decreases from the first flow rate to the second flow rate.

10. A substrate processing method comprising:
a substrate holding step of horizontally holding a substrate (W) having an upper surface covered with a solid or semi-solid polymer film (80),
a peeled portion (82)-forming step of tearing the polymer film (80) by a pressure of a peeling gas such that a peeled portion (82) that has been peeled from the upper surface of the substrate (W) and an adhering portion (83) adhering to the upper surface of the substrate (W) are included in the polymer film (80), by discharging the peeling gas at a first rate toward the upper surface of the substrate (W) through one or more peeling gas nozzles (33), and
a peeled portion (82)-widening step of converting the adhering portion (83) to the peeled portion (82) with the peeling gas that has entered between the peeled portion (82) and the substrate (W) by moving the one or more peeling gas nozzles (33) horizontally while discharging the peeling gas toward the upper surface of the substrate (W) through the one or more peeling gas nozzles (33) at a second rate which is slower than the first rate.

11. The substrate processing method according to Claim 10, wherein:
the peeled portion (82)-forming step includes a step of positioning the one or more peeling gas nozzles (33) at a first discharge position (P1) in which the peeling gas hits a non-device-forming region (R1) within the upper surface of the substrate (W), when the one or more peeling gas nozzles (33) discharge the peeling gas at the first rate, and
the peeled portion (82)-widening step includes a step of moving the one or more peeling gas nozzles (33) to a position in which the peeling gas hits a device-forming region (R2) within the upper surface of the substrate (W), when the one or more peeling gas nozzles (33) discharge the peeling gas at the second rate.

12. The substrate processing method according to Claim 10, wherein:
the polymer film (80) is a solid or semi-solid film containing a water-soluble polymer, and
the substrate processing method further comprises a rinse liquid supply step of causing a rinse liquid nozzle (32) to discharge rinse liquid containing water toward the upper surface of the substrate (W), after the polymer film (80) has been peeled from the upper surface of the substrate (W).

13. The substrate processing method according to Claim 12, further comprising a receiving step of receiving the polymer film (80) and rinse liquid that have scattered around the substrate (W) from the upper surface of the substrate (W) by a tubular guard (24).

14. The substrate processing method according to any one of Claims 10 to 13, further comprising:
a polymer solution supply step of causing a polymer solution nozzle (31) to discharge polymer solution toward the upper surface of the substrate (W) prior to the peeled portion (82)-forming step, and
a polymer film (80) forming step of converting a liquid film of the polymer solution on the substrate (W) to the polymer film (80) by heat generated from a heat source (71h).

15. The substrate processing method according to any one of Claims 10 to 14, wherein the peeled portion (82)-widening step includes a step of causing the one or more peeling gas nozzles (33) to discharge the peeling gas toward the upper surface of the substrate (W) until the entire polymer film (80) is peeled from the upper surface of the substrate (W) without being separated.
